Europäisches Patentamt

European Patent Office

Office européen des brevets

(19)

(11) **EP 1 108 623 A1**

(12) **EUROPÄISCHE PATENTANMELDUNG**

(43) Veröffentlichungstag:
**20.06.2001  Patentblatt 2001/25**

(51) Int Cl.⁷: **B60R 21/01**, H03M 1/06

(21) Anmeldenummer: **00125504.1**

(22) Anmeldetag: **21.11.2000**

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(30) Priorität: **15.12.1999  DE 19960560**

(71) Anmelder: **SIEMENS AKTIENGESELLSCHAFT
80333 München (DE)**

(72) Erfinder: **Hermann, Stefan
93096 Köfering (DE)**

(54) **Verfahren und System zum Übertragen eines Messwertes zu einer Steuereinrichtung, die mit einem Integral des Messwertes arbeitet**

(57)    Ein Verfahren zum ditigalen Übertragen eines analog erfaßten Meßwertes zu einer Steuereinrichtung, die mit einem Integral des Meßwertes arbeitet, wobei einem Eingang eines A/D-Wandlers, dessen Ausgangssignal zu der Steuereinrichtung übertragen wird, eine Summe aus dem Meßwert und einem Korrekturwert zugeführt wird, der aus der Differenz des integrierten Meßwertes und des integrierten Ausgangssignals gebildet ist, und das zur Steuereinrichtung übertragene Ausgangssignal vor seiner Weiterverarbeitung in der Steuereinrichtung integriert wird. Mit dem Verfahren kann unter Verwendung eines einfachen A/D-Wandlers eine genaue Übertragung des Integrals des Meßwertes erzielt werden.

EP 1 108 623 A1

**Beschreibung**

Die Erfindung betrifft ein Verfahren zum Übertragen eines Meßwertes zu einer Steuereinrichtung, die mit einem Integral des Meßwertes arbeitet. Die Erfindung betrifft weiter ein System zur Übertragung eines Meßwertes von einem Satelliten zu einer Steuereinrichtung, insbesondere in einem Insassenschutzsystem eines Kraftfahrzeugs.

Aus der Internationalen Patentanmeldung PCT/DE89/00048, von der im Oberbegriff des Anspruchs 2 ausgegangen wird, ist eine elektronische Einrichtung für die Sicherung von Fahrzeuginsassen bekannt, die eine Vielzahl von Sensoren enthält, die über eine im wesentlichen sternförmig verlaufende Leitung mit einem Steuergerät verbunden sind, das in Abhängigkeit von den Ausgangssignalen der Sensoren Rückhaltemittel aktiviert. Dabei sind die Sensoren in Satelliten angeordnet, die eine den Sensoren nachgeschaltete Auswerteschaltung enthalten, in denen die Ausgangssignale der Sensoren aufbereitet werden, um dann über Schnittstellen der Datenübertragungsstrecke zugeführt zu werden. In den Auswerteschaltungen wird beispielsweise ein Integral des Ausgangssignals des zugehörigen Sensors errechnet, das dann über die Übertragungsstrecke in digitaler Form übertragen wird.

Die Übertragungsgenauigkeit der Signale über die Übertragungsstrecke hängt von der Abtastrate, mit der die analogen Signale in digitale Signale umgesetzt werden, und der Anzahl der Quantisierungsstufen eines entsprechenden A/D-Wandlers ab. Entsprechend wird insbesondere bei der Datenübertragung innerhalb von Insassenschutzsystemen, bei denen Daten von einem oder mehreren Satelliten zu einem Steuergerät übertragen werden müssen, verhältnismäßig hoher Hardware-Aufwand betrieben.

Der Erfindung liegt die Aufgabe zugrunde, den Aufwand zu vermindern, der bei der Datenübertragung von einem Satelliten zu einer zentralen Steuereinrichtung eines Fahrzeuginsassen-Schutzsystems erforderlich ist.

Eine erste Lösung dieser Aufgabe wird mit Merkmalen des Anspruchs 1 gelöst.

Das erfindungsgemäße Verfahren macht sich zunutze, daß die in Fahrzeuginsassen-Schutzssystemen verwendeten Algorithmen im allgemeinen für die Auslösung eines Insassenschutzmittels nicht eine augenblickliche Fahrzeugverzögerung heranziehen, sondern ein Integral über die Fahrzeugverzögerung, das heißt, den Geschwindigkeitsabbau des Fahrzeugs. Entsprechend muß das Datenübertragungsverfahren derart ausgebildet sein, daß in der Steuereinrichtung der Wert des Integrals über die Fahrzeugverzögerung möglichst genau verfügbar ist. Dies wird mit dem erfindungsgemäßen Verfahren erreicht, bei dem weder der von einem Sensor erfaßte Verzögerungswert noch das Integral des Verzögerungswertes über die Datenübertragungsstrecke gesendet wird, sondern der im Anspruch 1 gekennzeichnete Wert, der nach seiner Übertragung integriert wird und in der Steuereinrichtung dann mit einem geringen Fehler gegenüber einem eingangsseitig gebildeten Integral der von dem Sensor erfaßten Verzögerung zur Verfügung steht. An den A/D-Wandler sind durch diese Art der Übertragung komprimierter Daten geringere Anforderungen gestellt; beispielsweise kann anstelle eines 8-Bit-Wandlers mit einem 6-Bit-Wandler gearbeitet werden.

Der Anspruch 2 kennzeichnet den grundsätzlichen Aufbau eines Systems, mit dem das Verfahren gemäß dem Anspruch 1 durchgeführt wird.

Der Anspruch 3 ist auf vorteilhafte Algorithmen gerichtet, mit denen das System bzw. das erfindungsgemäße Verfahren arbeitet.

Die Erfindung ist überall dort vorteilhaft anwendbar, wo von einem Sensor zu einer Zentraleinheit Daten digital übertragen werden müssen und in der Zentraleinheit die Sensorsignale selbst nicht hochgenau zur Verfügung stehen müssen, sondern ein Zeitintegral über das Sensorsignal. Anwendungsgebiete sind beispielsweise Druckübertragungen, wenn die Druckänderung eine Rolle spielt, Temperaturübertragungen, wenn die Temperaturänderung eine Rolle spielt, usw.

Gemäß dem Anspruch 4 eignet sich die Erfindung besonders gut für Fahrzeuginsassen-Schutzsysteme.

Die Erfindung wird im folgenden anhand einer schematischen Zeichnung beispielsweise und mit weiteren Einzelheiten erläutert.

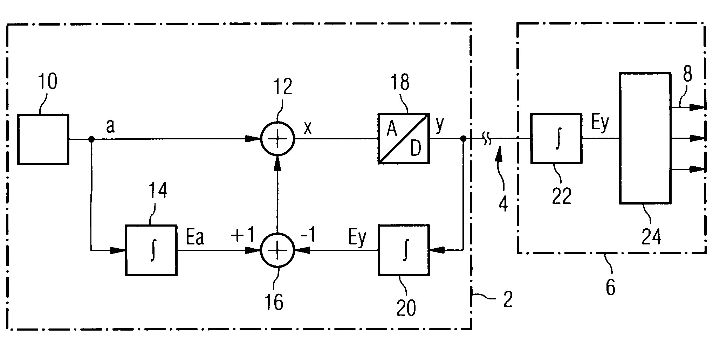

Die einzige Figur stellt ein Blockschaltbild des erfindungsgemäßen Systems dar.

Gemäß der Figur enthält ein Fahrzeuginsassen-Schutzsystem einen beispielsweise in der Seitentür oder im Vorderwagen angeordneten Satelliten 2, der über eine Datenübertragungsstrecke 4 mit einer Steuereinrichtung 6 verbunden ist, deren Ausgänge 8 mit nicht dargestellten Insassenschutzmitteln, wie Airbag-Einrichtungen, Gurtstraffern usw. verbunden sind.

Die Datenübertragungsstrecke 4 kann beispielsweise eine Leitung zum Übertragen serieller Daten sein, die zu einem Bussystem gehört.

Der Satellit 2 enthält einen Beschleunigungssensor 10, dessen analoges Ausgangssignal einem Addierglied 10 und einem Integrator 14 zugeführt wird. Der Ausgang des Integrators 14 ist mit dem Eingang eines weiteren Addiergliedes 16 verbunden, dessen Ausgang mit dem anderen Eingang des Addiergliedes 12 verbunden ist. Dem Addierglied 12 ist ein A/D-Wandler 18 nachgeschaltet, dessen Ausgang, gegebenenfalls unter Zwischenschaltung einer Schnittstelle, mit der Datenübertragungsstrecke 4 und einem Eingang eines weiteren Integrators 20 verbunden ist. Der Ausgang des Integrators 20 ist mit einem invertierenden Eingang des Addiergliedes 16 verbunden, das auf diese Weise ein Substrahierglied bildet. Nicht dargestellt ist ein Mikroprozessor, der den Betrieb des Satelliten steuert.

Die Steuereinrichtung 6 enthält einen der Da-

 **EP 1 108 623 A1**

tenübertragungsstrecke 4, gegebenenfalls unter Zwischenanordnung einer Schnittstelle, nachgeschalteten Integrator 22, dessen Ausgang mit einem Steuergerät 24 verbunden ist. Das Steuergerät 24 enthält einen nicht dargestellten Mikroprozessor, der den Betrieb auch des Integrators steuert.

Aufbau und Funktion der einzelnen Komponenten sowie von weiteren Steuerkomponenten, die die einzelnen Komponenten im Taktbetrieb steuern, sind an sich bekannt und werden daher nicht erläutert.

Die Gesamtfunktion des beschriebenen Systems ist folgende:

Es sei angenommen, der A/D-Wandler 18 erzeuge an seinem Ausgang im Takt k infolge der digitalen Wandlung ein um Aa zu großes gewandeltes Verzögerungssignal y. Dieses zu große gewandelte Verzögerungssignal y wird über die Datenübertragungsstrecke 4 dem Integrator 22 zugeführt und führt dort am Ende des Taktes k+1 zu einem zu großen Geschwindigkeitsabbausignal Ey. Weiter wird das Signal y dem Integrator 20 zugeführt und führt dort im Takt k+1 zu einem zu großen Geschwindigkeitsabbausignal Ey. Dieses zu große Geschwindigkeitsabbausignal Ey wird im Addierglied 16 von dem korrekten Geschwindigkeitsabbausignal Ea subtrahiert. Die Differenz wird im Addierglied 12 vom tatsächlichen Verzögerungssignal a abgezogen, so daß im Takt k+1 der Wandler 18 einen korrigierten und entsprechend zu kleinen korrigierten Wert x digitalisiert, der im Takt k+2 zu einem entsprechend korrigierten Geschwindigkeitsabbausignal Ey am Ausgang des Integrators 22 führt, usw.

Die beschriebene Schaltung führt insgesamt dazu, daß das Integral der vom Sensor 10 gemessenen Verzögerung Ea sich von dem am Ausgang des Integrators 22 abnehmbaren Integral Ey trotz Verwendung eines hinsichtlich seines Hardware-Aufwandes einfachen Wandlers 18 (beispielsweise 6 Bit anstelle 8 Bit) nur wenig unterscheidet, das heißt, daß gilt:

$$a(dt) - y(dt) < \varepsilon,$$

wobei $\varepsilon$ ein vorgebbarer Fehler ist.

Insgesamt gelten folgende Beziehungen mit den folgenden Bedeutungen der einzelnen Symbole:

Bedeutungen:

a = Beschleunigungssignal des Sensors 10
x = Eingangssignal des Wandlers 18
y = Ausgangssignal des Wandlers 18 (= Eingangssignal des Integrators 22)
Ea = Integral des Beschleunigungssignals (tatsächlicher Geschwindigkeitsabbau)
Ex = Integral des Eingangssignals x
Ey = Integral des Ausgangssignals y (= in der Steuereinrichtung 6 verfügbarer, übertragener Geschwindigkeitsabbau)
g = vom Einschwingverhalten des Geschwindigkeitsabbaus abhängige Konstante
s = Begrenzungswert für x
k = Taktzeitpunkt

Beziehungen:

$$Ea(k)=(1-g) \cdot Ea(k-1)+g \cdot a\,(k-1)$$

$$x(k)=a(k)+(Ea(k-1)-Ey(k-1))$$

$$Ey(k)=(1-g) \cdot Ey(k-1)+g \cdot y(k-1)$$

Der Taktzyklus im Satelliten läuft, solange x(k) >s; er endet, wenn x(k)≤s.

In der Steuereinrichtung stehen das Signal y(k) als unter Umständen von der tatsächlichen Verzögerung a stark abweichendes Signal und das Signal Ey(k) als mit dem Integral der tatsächlichen Verzögerung Ea(k) gut übereinstimmendes Signal zur Verfügung.

Im Folgenden wird eine Fehlerbetrachtung durchgeführt. Es sei angenommen, der maximale Fehler q(k), den a(k) nach Wandlung im Wandler 18 erfährt, sei q(k), wobei |q(k)| | < Q/2, wenn Q die Schrittweite des Wandlers 18 ist.

I. Bei einer Übertragung von a(k) über die Strecke 4 ohne Korrektur mit den Gliedern 12, 14, 16 und 20 gilt:

$$y(k) = a(k) + q(k),$$

und damit nach Integration im Integrator 22

$$\sum_{K=1}^{u} y(k) = \sum_{K=1}^{u} a(k) + \sum_{K=1}^{u} q(k)$$

Der maximale Fehler beträgt somit

$$F_{I} = \sum_{K=1}^{u} \left| q(k) \right|$$

II. Bei der erfindungsgemäßen Übertragung gilt:
y(k) = a(k) + (Ea(k-1) - Ey(k-1), und damit nach Integration:

$$\sum_{K=1}^{u} u(k) = \sum_{K=1}^{u} a(k) + \sum_{K=1}^{u} q(k) + \sum_{K=1}^{u-1} a(k) - \sum_{K=1}^{u-1} a(k) - \sum_{K=1}^{u-1} q(k)$$

$$= \sum_{K=1}^{u} a(k) + \sum_{K=1}^{u} q(k) - \sum_{K=1}^{u-1} q(k)$$

$$= \sum_{K=1}^{u} a(k) + q(k)$$

Der maximale Fehler beträgt somit $|q(k)|$.

Dieser Fehler ist erheblich kleiner als der Fehler gemäß I. und kann durch die Schrittweite des Wandlers 18 vorgegeben werden

**Patentansprüche**

1.  Verfahren zum ditigalen Übertragen eines analog erfaßten Meßwertes zu einer Steuereinrichtung, die mit einem Integral des Meßwertes arbeitet, dadurch gekennzeichnet,

    daß einem Eingang eines A/D-Wandlers, dessen Ausgangssignal zu der Steuereinrichtung übertragen wird, eine Summe aus dem Meßwert und einem Korrekturwert zugeführt wird, der aus der Differenz des integrierten Meßwertes und des integrierten Ausgangssignals gebildet ist, und
    daß das zur Steuereinrichtung übertragene Ausgangssignal vor seiner Weiterverarbeitung in der Steuereinrichtung integriert wird.

2.  System zur digitalen Übertragung eines analog erfaßten Meßwertes von einem Satelliten (2) zu einer Steuereinrichtung (6), insbesondere in einem Insassenschutzsystem eines Kraftfahrzeugs, bei welchem System die Steuereinrichtung mit einem Integral des Meßwertes arbeitet, welcher Satellit eine Signalverarbeitungsschaltung mit einem ersten Integrator und einem A/D-Wandler derart erhält, daß ein von einem Sensor erfaßter Meßwert in digitaler Form über eine Datenübertragungsstrecke (4) zu der Steuereinrichtung gesendet wird, dadurch gekennzeichnet,

    daß der Ausgang des Sensors (10) mit einem Eingang eines dem A/D-Wandler vorgeschalteten ersten Addiergliedes (12) und dem Eingang eines Integrators (14) verbunden ist,
    daß der Ausgang des A/D-Wandlers (18) mit dem Eingang eines weiteren Integrators (20) und dem Eingang der Datenübertragungsstrecke (4) verbunden ist,

    daß der Ausgang des ersten Integrators (14) mit einem Eingang eines zweiten Addiergliedes (16) verbunden ist, dessen anderer Eingang invertiert mit dem Ausgang des zweiten Integrators (20) verbunden ist,
    daß der Ausgang des zweiten Addiergliedes (16) mit dem weiteren Eingang des ersten Addiergliedes (12) verbunden ist, und daß der Ausgang der Übertragungsstrecke (4) mit einem Integrator (22) verbunden ist, dessen Ausgangssignal das Integral des Meßwertes bildet.

3.  Verfahren nach Anspruch 2, dadurch gekennzeichnet,
    daß das System entsprechend folgenden Algorithmen arbeitet:

    $$Ea(k) = (1-g) \cdot Ea(k-1) + g \cdot a(k-1)$$

    $$x(k) = a(k) + (Ea(k-1) - Ey(k-1))$$

    $$Ey(k) = (1-g) \cdot Ey(k-1) + g \cdot y(k-1) ;$$

    der Taktzyklus $(k)$ läuft, solange gilt: $x(k) > s$; er endet, wenn $x(k) \leq s$;
    es bedeuten:

    a = Beschleunigungssignal des Sensors 10
    x = Eingangssignal des Wandlers 18
    y = Ausgangssignal des Wandlers 18 (= Eingangssignal des Integrators 22)
    Ea = Integral des Beschleunigungssignals (tatsächlicher Geschwindigkeitsabbau)
    Ex = Integral des Eingangssignals x
    Ey = Integral des Ausgangssignals y (= in der Steuereinrichtung 6 verfügbarer, übertragener Geschwindigkeitsabbau)
    g = vom Einschwingverhalten des Geschwindigkeitsabbaus abhängige Konstante
    s = Begrenzungswert für x
    k = Taktzeitpunkt

4.  Verfahren nach Anspruch 2 oder 3, dadurch gekennzeichnet, daß der Sensor ein Beschleunigungssensor eines Fahrzeuginsassen-Schutzsystem ist und die Steuereinrichtung den Betrieb wenigstens eines Insassenschutzmittels steuert.

**Europäisches Patentamt**

## EUROPÄISCHER RECHERCHENBERICHT

Nummer der Anmeldung

EP 00 12 5504

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 898 395 A (LIDEN GARY ROSS ET AL) 27. April 1999 (1999-04-27) | 1-3 | B60R21/01 H03M1/06 |
| Y | * Spalte 2, Zeile 50 - Zeile 56 * <br> * Spalte 4, Zeile 22 - Zeile 44 * <br> * Spalte 5, Zeile 9 - Zeile 11; Abbildungen 1,2,5 * <br> * Zusammenfassung * <br> --- | 4 | |
| Y | US 4 984 464 A (THOMAS ALAN D ET AL) 15. Januar 1991 (1991-01-15) * Spalte 1, Zeile 29 - Zeile 41; Abbildung 1 * <br> * Zusammenfassung * <br> --- | 4 | |
| A | US 5 872 532 A (YASUDA AKIRA) 16. Februar 1999 (1999-02-16) * Zusammenfassung; Abbildungen 9,25-31 * <br> --- | 1-3 | |
| A | US 5 539 403 A (KANEAKI TETSUHIKO ET AL) 23. Juli 1996 (1996-07-23) * Spalte 18, Zeile 12 - Zeile 21 * <br> * Spalte 20, Zeile 3 - Zeile 44; Abbildungen 15,19 * <br> * Zusammenfassung * <br> --- | 1-3 | **RECHERCHIERTE SACHGEBIETE (Int.Cl.7)** <br> G01P <br> B60R <br> H03M |
| A | FIEZ T S ET AL: "DELTA-SIGMA A/D CONVERTERS: THE NEXT GENERATION" SACRAMENTO, CA, AUG. 3 - 6, 1997,NEW-YORK, NY: IEEE,US, 3. August 1997 (1997-08-03), Seiten 181-184, XP000787751 ISBN: 0-7803-3695-X * das ganze Dokument * <br> --- <br> -/-- | 1-3 | |

Der vorliegende Recherchenbericht wurde für alle Patentansprüche erstellt

| Recherchenort | Abschlußdatum der Recherche | Prüfer |
|---|---|---|
| BERLIN | 14. März 2001 | Wauters, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 00 12 5504

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | PARRY S: "ADVANCES IN ADCS A-TO-D CONVERSION" ELECTRONICS WORLD AND WIRELESS WORLD,GB,REED BUSINESS PUBLISHING, SUTTON, SURREY, Bd. 101, Nr. 1706, 1995, Seiten 24-25, XP000489158 ISSN: 0959-8332 * das ganze Dokument * ----- | 1-3 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| BERLIN | 14. März 2001 | Wauters, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                EP 00 12 5504

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-03-2001

| Im Recherchenbericht angeführtes Patentdokument | Datum der Veröffentlichung | Mitglied(er) der Patentfamilie | Datum der Veröffentlichung |
|---|---|---|---|
| US 5898395 A | 27-04-1999 | KEINE | |
| US 4984464 A | 15-01-1991 | WO 8807461 A | 06-10-1988 |
| US 5872532 A | 16-02-1999 | JP 9186601 A<br>CN 1126396 A<br>EP 0704978 A<br>JP 8154058 A | 15-07-1997<br>10-07-1996<br>03-04-1996<br>11-06-1996 |
| US 5539403 A | 23-07-1996 | JP 2822776 B<br>JP 5335963 A<br>JP 6252768 A<br>EP 0597123 A<br>WO 9325006 A | 11-11-1998<br>17-12-1993<br>09-09-1994<br>18-05-1994<br>09-12-1993 |

EPO FORM P0461

Für nähere Einzelheiten zu diesem Anhang : siehe Amtsblatt des Europäischen Patentamts, Nr.12/82